# EUROPEAN PATENT APPLICATION

(11) **EP 4 528 794 A2**
(43) Date of publication of application: **26.03.2025**
(21) Application number: 24197925.1
(22) Date of filing: 02.09.2024
(51) Int. Cl.: H01L 21/67, H01L 21/68, H01L 21/687

(54) **APPARATUS FOR AND METHOD OF PROCESSING SUBSTRATE**

(30) Priority: 19.09.2023 JP 2023150789
(71) Applicant: SCREEN Holdings Co., Ltd., Kyoto-shi, Kyoto 602-8585 (JP)
(72) Inventor: KUWAHARA, Joji, Kyoto, 602-8585 (JP)
(74) Representative: Kilian Kilian & Partner mbB

(57) **Abstract**

A substrate processing apparatus includes optical sensors (46) and a controller (30). The optical sensors (46) emit and receive inspection light in detection positions (P1, P2) on an advancing/retracting path of a substrate (W), and output a light blocking signal when the amount of inspection light received is lower than a threshold value. The controller (30) detects the position of an edge (E) of the substrate (W), based on a falling edge of the light blocking signal, when the substrate (W) moves away from the detection position (P1). The controller (30) detects the position of the edge (E) of the substrate (W), based on a rising edge of the light blocking signal, when the substrate (W) moves toward the detection position (P2). Thus, the position of the edge (E) of the substrate (W) is detected based on the signal of a portion closest to the outside of the substrate (W) among light blocking signals outputted near the edge (E) of the substrate (W). This allows the position of the edge (E) of the substrate (W) to be detected appropriately.

## Description

### BACKGROUND OF THE INVENTION

### Field of the Invention

The present invention relates to a substrate processing apparatus and a substrate processing method which process a transparent substrate.

### Description of the Background Art

Conventionally, a substrate processing apparatus which performs a plurality of processes including the application of a processing liquid, development, heat treatment, cleaning, and the like on a substrate is used in the process steps of manufacturing semiconductor wafers and substrates for liquid crystal displays and the like. In this type of apparatus, substrates are transported between multiple processing units by a transport robot. A conventional substrate processing apparatus having a transport robot is disclosed, for example, in Japanese Patent Application Laid-Open No. 2018-133415.

A conventional transport robot includes a transmission-type optical sensor which detects the position of an edge of a substrate. The optical sensor emits inspection light from a light emitter located below a substrate transport path toward a photodetector located above the substrate transport path. A controller then recognizes the point in time at which a change occurs between the presence and absence of inspection light received by the photodetector as the point in time at which the edge of the substrate has passed.

However, if the substrate to be processed is transparent, the inspection light of the optical sensor is transmitted through the substrate without being blocked by the substrate. It is hence difficult to detect the edge of the transparent substate with accuracy using the same method as before.

### SUMMARY OF THE INVENTION

In view of the foregoing, it is therefore an object of the present invention to provide a substrate processing apparatus and a substrate processing method which are capable of properly detecting the position of an edge of a transparent substrate.

To solve the aforementioned problem, a first aspect of the present invention is intended for a substrate processing apparatus for processing a transparent substrate, which comprises: a hand for holding a substrate; an advancing/retracting mechanism for moving the hand back and forth along a predetermined advancing/retracting path; at least one optical sensor for emitting and receiving inspection light in a detection position on the advancing/retracting path, the optical sensor outputting a light blocking signal when the amount of inspection light received is lower than a threshold value; and a controller for detecting the position of an edge of the substrate, based on the light blocking signal, wherein the controller detects the position of the edge of the substrate, based on a rising edge of the light blocking signal, when the substrate moves toward the detection position, and wherein the controller detects the position of the edge of the substrate, based on a falling edge of the light blocking signal, when the substrate moves away from the detection position.

A second aspect of the present invention is intended for the substrate processing apparatus of the first aspect, wherein the advancing/retracting mechanism moves the hand back and forth between a home position in which the substrate is stored and a transfer position in which the substrate is transferred, and wherein the controller detects the position of the edge of the substrate in the course of movement of the hand from the transfer position to the home position.

A third aspect of the present invention is intended for the substrate processing apparatus of the second aspect, wherein the optical sensor is located near the home position.

A fourth aspect of the present invention is intended for the substrate processing apparatus of any one of the first to third aspects, wherein the at least one optical sensor includes: a first optical sensor for detecting a rear end portion of the substrate as seen in a movement direction thereof in a first detection position on the advancing/retracting path; and a second optical sensor for detecting a front end portion of the substrate as seen in the movement direction thereof in a second detection position closer to the home position than the first detection position.

A fifth aspect of the present invention is intended for the substrate processing apparatus of any one of the first to fourth aspects, wherein the controller calculates the position of the substrate relative to the hand, based on the detected position of the edge.

A sixth aspect of the present invention is intended for the substrate processing apparatus of the fifth aspect, which further comprises: a plurality of processing units; and a transport robot for transporting the substrate between the processing units, wherein the transport robot includes the hand, the advancing/retracting mechanism, and the optical sensor, wherein the controller calculates the relative position when transporting the substrate out of one of the processing units, and wherein the controller adjusts the position of the hand, based on the relative position, when transporting the substrate into another of the processing units.

A seventh aspect of the present invention is intended for a method of processing a transparent substrate, which comprises the steps of: (a) emitting and receiving inspection light in a detection position on an advancing/retracting path of a substrate, and outputting a light blocking signal when the amount of inspection light received is lower than a threshold value; and (b) detecting the position of an edge of the substrate, based on the light blocking signal, the steps (a) and (b) being performed by a controller, wherein, in the step (b), the controller detects the position of the edge of the substrate, based on a rising edge of the light blocking signal, when the substrate moves toward the detection position, and detects the position of the edge of the substrate, based on a falling edge of the light blocking signal, when the substrate moves away from the detection position.

According to the first to seventh aspects of the present invention, the position of the edge of the substrate is detected based on the signal of a portion closest to the outside of the substrate among light blocking signals outputted near the edge of the substrate. This allows the position of the edge of the transparent substrate to be detected appropriately.

In particular, according to the third aspect of the present invention, the position of the edge of the substrate is detected when the movement speed of the substrate is decreasing immediately before the hand is stopped in the home position. This allows the position of the edge of the substrate to be detected more accurately.

In particular, according to the fourth aspect of the present invention, the rear and front end portions of the substrate are detected by the separate optical sensors. This allows the acquisition of the light blocking signals only near the edge of the substrate. Thus, the position of the edge of the substrate is detected without consideration of the light blocking signal coming from a pattern near the center of the substrate.

In particular, according to the sixth aspect of the present invention, with consideration given to the position of the substrate relative to the hand when the substrate is transported out of one processing unit, the substrate is located in a predetermined position accurately when the substrate is transported into another processing unit.

These and other obj ects, features, aspects and advantages of the present invention will become more apparent from the following detailed description of the present invention when taken in conjunction with the accompanying drawings.

### BRIEF DESCRIPTION OF THE DRAWINGS

Fig. 1 is a plan view of a substrate processing apparatus;
Fig. 2 is a control block diagram of the substrate processing apparatus;
Fig. 3 is a side view of a transport robot;
Fig. 4 is a top view of a hand;
Fig. 5 is a flow diagram showing a procedure for operation when the transport robot transports a substrate from a first processing unit to a second processing unit;
Fig. 6 is a flow diagram showing a procedure for the process of detecting the position of a substrate;
Figs. 7 to 11 are views showing positional relationships between optical sensors and a substrate in Step S11; and
Figs. 12 and 13 are graphs showing examples of signals outputted from the optical sensors.

### DESCRIPTION OF THE PREFERRED EMBODIMENTS

A preferred embodiment according to the present invention will now be described in detail with reference to the drawings.

### <1. Overall Configuration of Substrate Processing Apparatus>

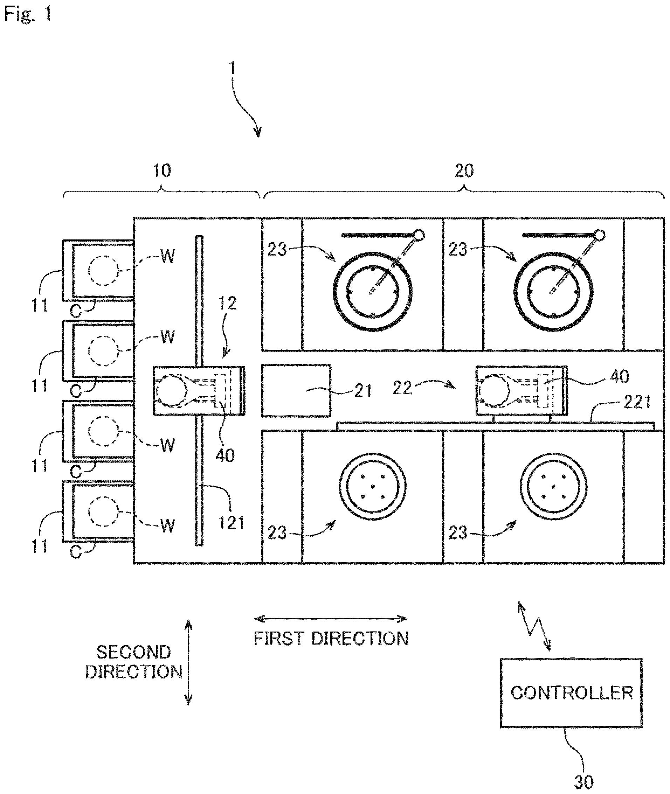

Fig. 1 is a plan view of a substrate processing apparatus 1 according to one preferred embodiment of the present invention. This substrate processing apparatus 1 is an apparatus which performs processes including the application of a processing liquid, development, heat treatment, cleaning, and the like on a transparent disk-shaped substrate W. The substrate W is, for example, a substrate for a liquid crystal display. However, the substrate W may be a carrier board for supporting a silicon wafer. The material of the substrate W may be glass or silicon carbide (SiC). The substrate W may be either colorless and transparent or colored and transparent.

As shown in Fig. 1, the substrate processing apparatus 1 includes an indexer block 10, a processing block 20, and a controller 30. The indexer block 10 and the processing block 20 are disposed adjacent to each other on a horizontal floor. A direction in which the indexer block 10 and the processing block 20 are arranged is referred to hereinafter as a "first direction", and a horizontal direction orthogonal to the first direction is referred to hereinafter as a "second direction".

The indexer block 10 is a section for transporting an unprocessed substrate W from the outside into the substrate processing apparatus 1 and for transporting a processed substrate W out of the substrate processing apparatus 1 to the outside. As shown in Fig. 1, the indexer block 10 includes a plurality of carrier rest parts 11 and a first transport part 12. The indexer block 10 includes, for example, four carrier rest parts 11. The carrier rest parts 11 are arranged in the second direction. Each of the carrier rest parts 11 is capable of setting thereon a carrier C for accommodating a plurality of substrates W. For example, a FOUP (front opening unified pod) may be used for the carrier C.

The first transport part 12 is located between the plurality of carrier rest parts 11 and the processing block 20. The first transport part 12 includes a first transport passage 121 extending in the second direction, and a transport robot 40. The transport robot 40 is movable along the first transport passage 121 in the second direction.

The first transport part 12 transports a substrate W between the carriers C and a buffer 21 to be described later while holding the substrate W by means of the transport robot 40. In other words, the transport robot 40 of the first transport part 12 takes out an unprocessed substrate W out of each of the carriers C and transports the unprocessed substrate W to the buffer 21. Also, the transport robot 40 of the first transport part 12 takes out a processed substrate W out of the buffer 21 and transports the processed substrate W to each of the carriers C.

The processing block 20 is a section for performing various processes on a plurality of substrates W transported from the indexer block 10. As shown in Fig. 1, the processing block 20 includes the buffer 21, a second transport part 22, and a plurality of processing units 23. The buffer 21 is a unit for temporarily stores a substrate W between the first transport part 12 and the second transport part 22. The buffer 21 is capable of accommodating a plurality of substrates W at the same time.

The second transport part 22 includes a second transport passage 221 extending in the first direction, and a transport robot 40. The transport robot 40 is movable along the second transport passage 221 in the first direction. The second transport part 22 transports a substrate W between the buffer 21 and the plurality of processing units 23 while holding the substrate W by means of the transport robot 40. In other words, the transport robot 40 of the second transport part 22 takes out an unprocessed substrate W out of the buffer 21 and transports the unprocessed substrate W to the first one of the processing units 23. Also, the transport robot 40 of the second transport part 22 transports substrates W sequentially between the processing units 23. Also, the transport robot 40 of the second transport part 22 takes out a processed substrate W out of the last one of the processing units 23 and transports the processed substrate W to the buffer 21.

The processing block 20 may include two or more second transport parts 22. For example, second transport passages 221 may be provided in tiers arranged in a vertical direction, and the transport robot 40 may be provided for each of the second transport passages 221.

Each of the processing units 23 is what is called a single-wafer type processing part which processes substrates W one at a time. The processing units 23 are disposed on both sides of the second transport passage 221 in the second direction. The processing units 23 include multiple types of processing units, e.g. a liquid processing unit for supplying a processing liquid to a substrate W while rotating the substrate W, a heating processing unit for heating a substrate W, and a cooling processing unit for cooling a substrate W.

In the example of Fig. 1, a total of four processing units 23 are disposed, two on each side of the second transport passage 221. However, the number of processing units 23 disposed on both sides of the second transport passage 221 is not limited to that shown in the example of Fig. 1. Alternatively, the processing units 23 may be provided in tiers arranged in the height direction.

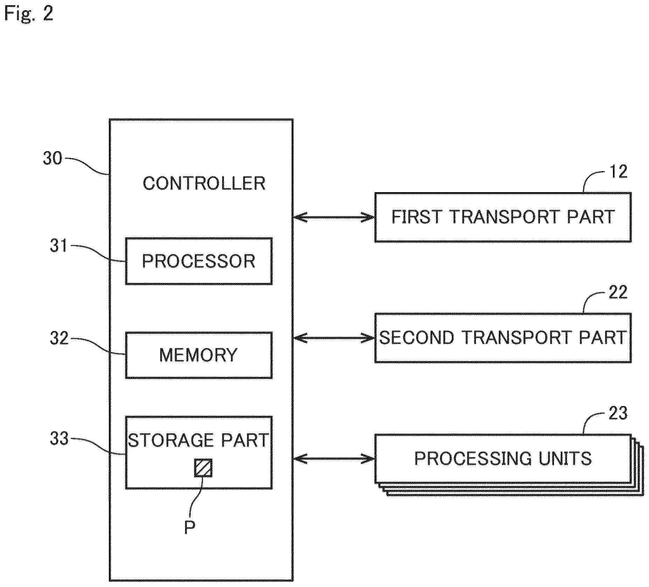

The controller 30 is an information processing device for controlling the parts of the substrate processing apparatus 1. Fig. 2 is a control block diagram of the substrate processing apparatus 1. As conceptually shown in Fig. 2, the controller 30 is formed by a computer including a processor 31 such as a CPU, a memory 32 such as a RAM, and a storage part 33 such as a hard disk drive. A control program P is stored in the storage part 33. The control program P is a computer program for controlling the operations of the parts of the substrate processing apparatus 1 for the purpose of executing the processes of the substrates W.

As shown in Fig. 2, the controller 30 is electrically connected to the aforementioned first and second transport parts 12 and 22. Specifically, the controller 30 is electrically connected to the transport robot 40 of each of the first and second transport parts 12 and 22. The controller 30 is also electrically connected to substrate rotating mechanisms, processing liquid supply mechanisms, temperature control mechanisms, and the like of the respective processing units 23. The controller 30 controls the operations of the aforementioned parts in accordance with the control program P stored in the storage part 33. This causes various processes including the transport of substrates W in the substrate processing apparatus 1 to proceed.

### <2. Transport Control of Transport Robot>

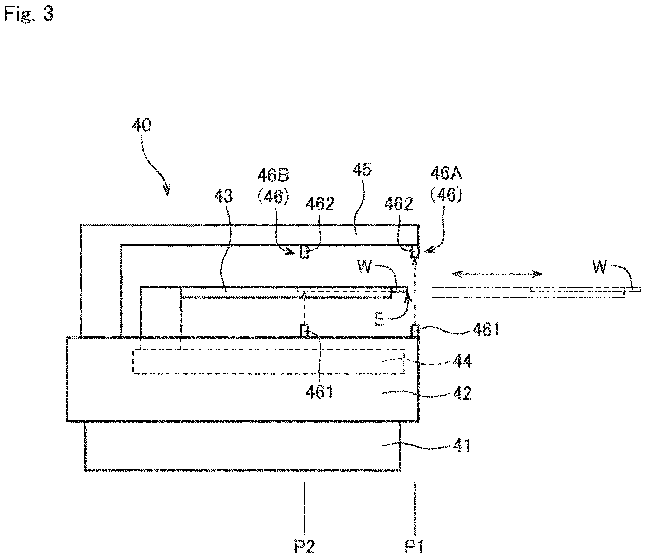

Subsequently, the transport control of a substrate W by means of the aforementioned transport robot 40 will be described in more detail. Fig. 3 is a side view of the transport robot 40. As shown in Fig. 3, the transport robot 40 includes a base portion 41, a rotary table 42, a hand 43, an advancing/retracting mechanism 44, a bracket 45, and a plurality of optical sensors 46.

The base portion 41 is located under the rotary table 42. The base portion 41 moves in a horizontal direction along the first transport passage 121 or the second transport passage 221. The rotary table 42 is supported rotatably with respect to the base portion 41. A rotary mechanism including a motor is provided between the base portion 41 and the rotary table 42. When the rotary mechanism is operated, the rotary table 42 rotates about an axis extending in a vertical direction.

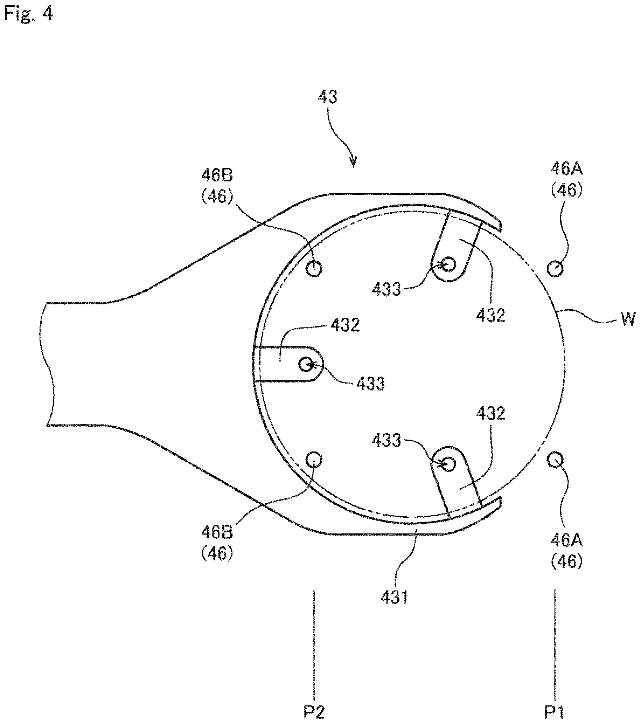

The hand 43 is a holder for holding a substrate W. The hand 43 is located over the rotary table 42. Fig. 4 is a top view of the hand 43. As shown in Fig. 4, the hand 43 includes a hand body 431 of a generally arcuate shape as seen in top view, and three suction portions 432 extending inwardly from the hand body 431. In Fig. 4, the substrate W held by the hand 43 is shown in a phantom line (in a dash-double-dot line).

As shown in Fig. 4, the substrate W is disposed inside the arcuate hand body 431, and is placed on upper surfaces of the three suction portions 432. A lower surface of the substrate W is suctioned by suction holes 433 provided in the suction portions 432. This fixes the position of the substrate W with respect to the hand 43.

However, as shown in Fig. 4, the inner diameter of the hand body 431 is slightly greater than the outer diameter of the substrate W. Thus, the position of the substrate W with respect to the hand 43 is not exactly constant. The position of the substrate W with respect to the hand 43 can be deviated within the range of a minute gap between the hand body 431 and the substrate W.

The advancing/retracting mechanism 44 is a mechanism for moving the hand 43 back and forth along a horizontal advancing/retracting path. As an example, a mechanism for converting a rotary motion outputted from a motor into a linear motion by way of a ball screw is used as the advancing/retracting mechanism 44. The advancing/retracting mechanism 44 moves the hand 43 back and forth between a home position in which a substrate W is stored between the rotary table 42 and the bracket 45 and a transfer position in which the substrate W protrudes forwardly from the home position. In Fig. 3, the hand 43 and the substrate W in the home position are shown in solid lines, and the hand 43 and the substrate W in the transfer position are shown in dash-double-dot lines. The hand 43 is located in the home position when the transport robot 40 moves along the first transport passage 121 or the second transport passage 221. The hand 43 is located in the transfer position when the transport robot 40 transfers the substrate W to and from a substrate holding part in each of the processing units 23.

The bracket 45 is a frame for holding photodetectors 462 to be described later of the optical sensors 46. The bracket 45 is fixed to the rotary table 42.

The four optical sensors 46 are transmission-type sensors which detect the position of an edge E of the substrate W on the advancing/retracting path of the substrate W. Fig. 4 shows the positions of the optical sensors 46 when the hand 43 is located in the home position. As shown in Fig. 4, the four optical sensors 46 are disposed near the hand 43 located in the home position.

The optical sensors 46 include two first optical sensors 46A and two second optical sensors 46B. The two first optical sensors 46A are disposed in a first detection position P1 on the advancing/retracting path of the substrate W. The first detection position P1 is a position slightly closer to the transfer position than the substrate W held by the hand 43 located in the home position. The two second optical sensors 46B are disposed in a second detection position P2 which is closer to the home position than the first detection position P1. The two second optical sensors 46B are located so as to overlap the substrate W held by the hand located in the home position as seen in top view.

As shown in Fig. 3, each of the four optical sensors 46 includes a light emitter 461 and a photodetector 462. The light emitter 461 is fixed to the rotary table 42. The photodetectors 462 is fixed to the bracket 45. The light emitter 461 emits inspection light toward the photodetector 462. When there is no light-blocking object between the light emitter 461 and the photodetectors 462, the inspection light emitted from the light emitter 461 is received by the photodetector 462. When there is a light-blocking object between the light emitter 461 and the photodetectors 462, the amount of inspection light received by the photodetector 462 is reduced.

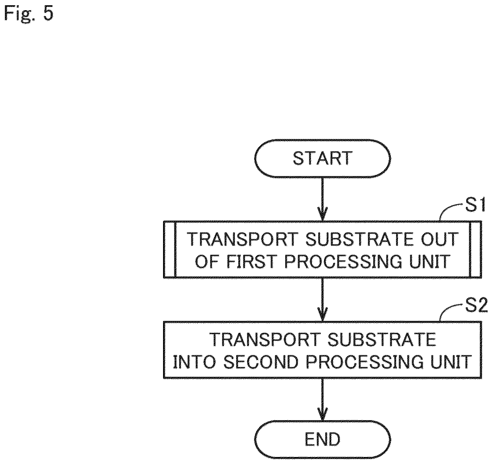

Fig. 5 is a flow diagram showing a procedure for operation when the transport robot 40 of the second transport part 22 transports a substrate W from one processing unit 23 to another processing unit 23. "One processing unit 23" out of which the substrate W is transported is referred to hereinafter as a "first processing unit 23A", and "another processing unit 23" into which the substrate W is transported is referred to hereinafter as a "second processing unit 23B".

As shown in Fig. 5, the transport robot 40 initially transports the substrate W out of the first processing unit 23A (Step S1). Specifically, the transport robot 40 initially moves along the second transport passage 221 to the front of the first processing unit 23A. Next, the transport robot 40 rotates the rotary table 42 to point the tip of the hand 43 toward the first processing unit 23A. Subsequently, the transport robot 40 moves the hand 43 from the home position to the transfer position by means of the advancing/retracting mechanism 44. Then, the transport robot 40 holds the substrate W located in the first processing unit 23A by placing and suctioning the substrate W on the suction portions 432 of the hand 43.

Thereafter, the transport robot 40 moves the hand 43 holding the substrate W from the transfer position to the home position. As a result, the substrate W is transported out of the first processing unit 23A. At this time, the position of the substrate W with respect to the hand 43 is slightly deviated from an ideal position in some cases, as mentioned above. For this reason, the process of detecting the position of the substrate W relative to the hand 43 is performed by the optical sensors 46 in the substrate processing apparatus 1 in the course of movement of the hand 43 from the transfer position to the home position.

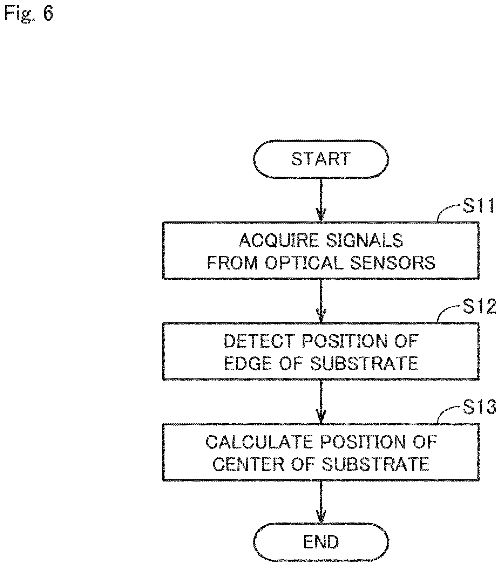

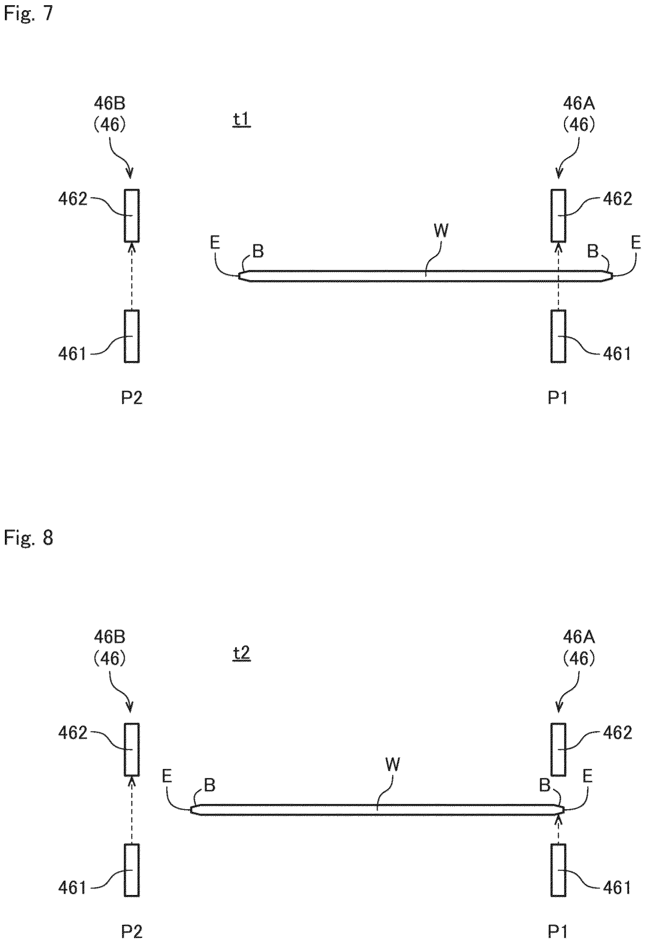

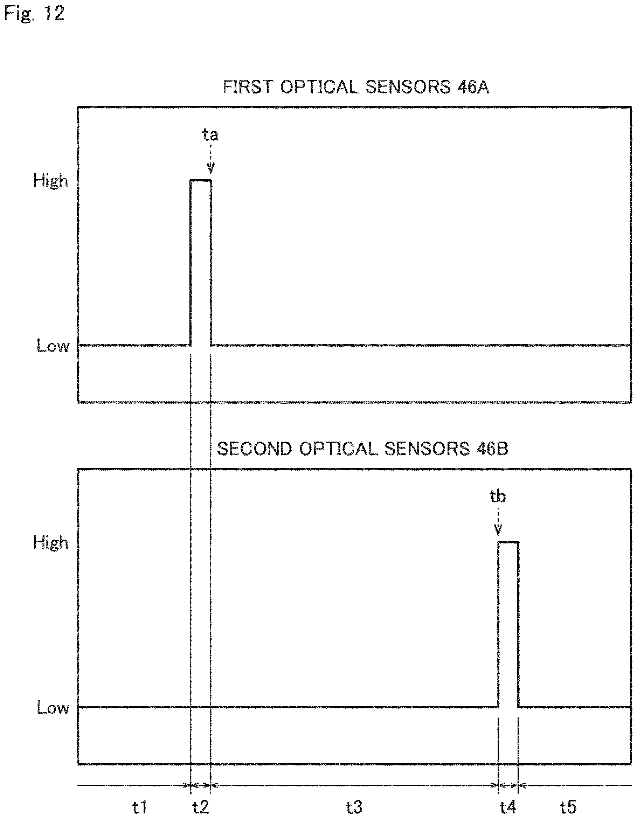

Fig. 6 is a flow diagram showing a procedure for the process of detecting the position of the substrate W. As shown in Fig. 6, the controller 30 initially acquires signals outputted from the optical sensors 46 as the substrate W moves (Step S11: signal output step). Figs. 7 to 11 are views showing positional relationships between the optical sensors 46 and the substrate W in Step S11. Fig. 12 is a graph showing examples of signals outputted from the first optical sensors 46A and the second optical sensors 46B in Step S 11. In Fig. 12, the abscissa represents time, and the ordinate represents the level of signals.

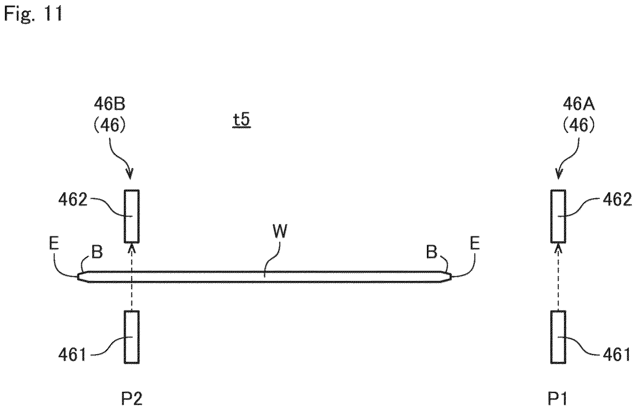

As shown in Figs. 7 to 11, the substrate W moves toward the home position between the light emitters 461 and photodetectors 462 of the optical sensors 46 whose positions are fixed with respect to the rotary table 42. The position of the hand 43 holding the substrate W in the state shown in Fig. 11 is the home position. In the present preferred embodiment, the edge E of the substrate W is detected by the optical sensors 46 immediately before the substrate W stops in the home position.

After a front end portion of the substrate W as seen in the movement direction thereof passes through the first optical sensors 46A, a main surface of the substrate W moves between the light emitters 461 and photodetectors 462 of the first optical sensors 46A, as shown in Fig. 7. The main surface of the substrate W is a surface of the substrate W with the largest area. At this time, the inspection light emitted from the light emitters 461 passes through the substrate W and is received by the photodetectors 462 because the substrate W is transparent. In this case, a signal outputted from the first optical sensors 46A is a "Low" signal, as indicated during a time period t1 in Fig. 12. The "Low" signal is a light transmission signal indicating that the light is transmitted through the substrate W.

During the time period 11, the inspection light emitted from the light emitters 461 also enters the photodetectors 462 in the second optical sensors 46B. Thus, a signal outputted from the second optical sensors 46B is also a "Low" signal during the time period t1.

A beveled portion B, which is beveled, is provided near the edge E of the substrate W. When the hand 43 holds the substrate W so that the main surface is horizontal, the surface of the beveled portion B is inclined with respect to a horizontal plane.

After the state of Fig. 7, the beveled portion B of a rear end portion of the substrate W as seen in the movement direction thereof passes between the light emitters 461 and photodetectors 462 of the first optical sensors 46A, as shown in Fig. 8. At this time, part of the inspection light emitted from the light emitters 461 of the first optical sensors 46A is refracted or reflected by the beveled portion B, thereby deviating from the optical axis. For this reason, the amount of inspection light received by the photodetectors 462 of the first optical sensors 46A becomes lower than a preset threshold value. In this case, the signal outputted from the first optical sensors 46A is a "High" signal, as indicated during a time period t2 in Fig. 12. The "High" signal is a light blocking signal indicating that the light is blocked.

On the other hand, the inspection light emitted from the light emitters 461 also enters the photodetectors 462 in the second optical sensors 46B during the time period t2. Thus, the signal outputted from the second optical sensors 46B is still the "Low" signal during the time period t2.

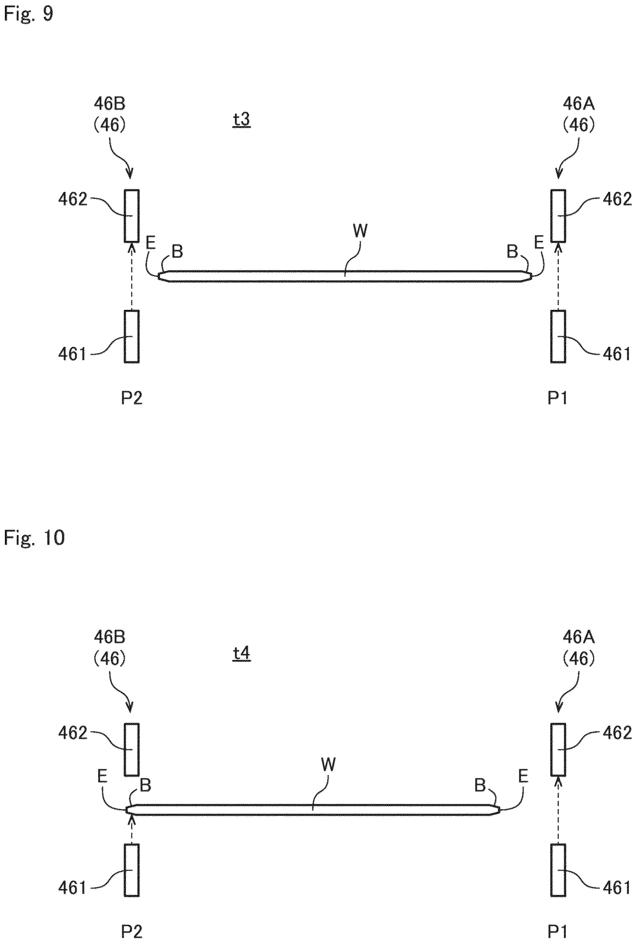

In the present preferred embodiment, the distance between the first optical sensors 46A and the second optical sensors 46B as measured in the movement direction of the substrate W is greater than the dimension of the substrate W as measured in the movement direction thereof. Thus, after the substrate W passes through the first optical sensors 46A, the substrate W is in a position where the substrate W overlaps neither the first optical sensors 46A nor the second optical sensors 46B, as shown in Fig. 9. In this case, the inspection light emitted from the light emitters 461 enters the photodetectors 462 in both the first optical sensors 46A and the second optical sensors 46B. Thus, both the signal outputted from the first optical sensors 46A and the signal outputted from the second optical sensors 46B are "Low" signals, as indicated during a time period t3 in Fig. 12.

After the state of Fig. 9, the beveled portion B of the front end portion of the substrate W as seen in the movement direction thereof passes between the light emitters 461 and photodetectors 462 of the second optical sensors 46B, as shown in Fig. 10. At this time, part of the inspection light emitted from the light emitters 461 of the second optical sensors 46B is refracted or reflected by the beveled portion B, thereby deviating from the optical axis. For this reason, the amount of inspection light received by the photodetectors 462 of the second optical sensors 46B becomes lower than the preset threshold value. In this case, the signal outputted from the second optical sensors 46B is the "High" signal, as indicated during a time period t4 in Fig. 12.

On the other hand, the inspection light emitted from the light emitters 461 also enters the photodetectors 462 in the first optical sensors 46A during the time period t4. Thus, the signal outputted from the first optical sensors 46A is still the "Low" signal during the time period t4.

Thereafter, the main surface (the surface with the largest area) of the substrate W moves to between the light emitters 461 and photodetectors 462 of the second optical sensors 46B, as shown in Fig. 11. Then, the inspection light emitted from the light emitters 461 passes through the substrate W and is received by the photodetectors 462 because the substrate W is transparent. In this case, the signal outputted from the second optical sensors 46B is the "Low" signal, as indicated during a time period t5 in Fig. 12.

During the time period t5, the inspection light emitted from the light emitters 461 also enters the photodetectors 462 in the first optical sensors 46A. Thus, the signal outputted from the first optical sensors 46A is also the "Low" signal during the time period t5.

Referring again to Fig. 6, after acquiring the aforementioned signals from the optical sensors 46, the controller 30 detects the position of the edge E of the substrate W, based on the signals (Step S12: detection step). The edge E is the outermost periphery of the substrate W. In other words, the edge E is the outermost portion of the beveled portion B.

The controller 30 judges that a falling edge of the "High" signal from the first optical sensors 46A in Fig. 12 which is indicated by a dashed arrow as a signal corresponding to the edge E of the rear end portion of the substrate W as seen in the movement direction thereof. This is because the edge E is the last portion of the beveled portion B which passes through the first detection position P1 in a situation where the substrate W moves away from the first detection position P1, as shown in Fig. 8.

The controller 30 detects the position of the edge E of the rear end portion of the substrate W as seen in the movement direction thereof, based on a time ta corresponding to the falling edge of the "High" signal. More specifically, the controller 30 stores a count value of a pulse signal outputted from an encoder provided in the advancing/retracting mechanism 44 in the storage part 33 as a count value corresponding to the edge E of the rear end portion of the substrate W at the time ta corresponding to the falling edge of the "High" signal. Then, the controller 30 calculates the position of the edge E of the rear end portion of the substrate W relative to the position of the hand 43 at the time ta.

The controller 30 judges that a rising edge of the "High" signal from the second optical sensors 46B in Fig. 12 which is indicated by a dashed arrow as a signal corresponding to the edge E of the front end portion of the substrate W as seen in the movement direction thereof. This is because the edge E is the first portion of the beveled portion B which passes through the second detection position P2 in a situation where the substrate W moves toward the second detection position P2, as shown in Fig. 10.

The controller 30 detects the position of the edge E of the front end portion of the substrate W as seen in the movement direction thereof, based on a time tb corresponding to the rising edge of the "High" signal. More specifically, the controller 30 stores the count value of the pulse signal outputted from the encoder provided in the advancing/retracting mechanism 44 in the storage part 33 as a count value corresponding to the edge E of the front end portion of the substrate W at the time tb corresponding to the rising edge of the "High" signal. Then, the controller 30 calculates the position of the edge E of the front end portion of the substrate W relative to the position of the hand 43 at the time tb.

As shown in Fig. 4, the transport robot 40 includes the aforementioned two pairs of first and second optical sensors 46A and 46B. In Step S12, the controller 30 detects the position of the edge E relative to the hand 43, based on the signals outputted from these four optical sensors 46. This detects four positions of the edge E of the substrate W relative to the hand 43.

Subsequently, the controller 30 calculates the position of the center of the substrate W relative to the hand 43, based on the four positions of the edge E thus obtained (Step S13). The position of the center of the substrate W can be calculated if at least three positions of the edge E are known. However, there are cases in which the substrate W has a notch in one position of the edge E. For this reason, the controller 30 calculates the position of the center of the substrate W, based on the four positions of the edge E. Even if one of the four detected positions of the edge E is a notch, this allows the accurate calculation of the position of the center of the substrate W based on the remaining three positions of the edge E. The controller 30 stores the calculated position of the center of the substrate W relative to the hand 43 in the storage part 33.

Referring again to Fig. 5, after the transport of the substrate W out of the first processing unit 23A is completed, the transport robot 40 transports the substrate W into the second processing unit 23B (Step S2). Specifically, the transport robot 40 moves along the second transport passage 221 from the front of the first processing unit 23A to the front of the second processing unit 23B. Next, the transport robot 40 rotates the rotary table 42 to point the tip of the hand 43 toward the second processing unit 23B. Subsequently, the transport robot 40 moves the hand 43 from the home position to the transfer position by means of the advancing/retracting mechanism 44. Then, the transport robot 40 releases the suction of the substrate W by means of the suction portions 432, and transfers the substrate W to a predetermined position in the second processing unit 23B.

At this time, the controller 30 makes fine adjustments to the position of the hand 43, based on the position of the substrate W relative to the hand 43 calculated in Step S13 described above. For example, if the position of the substrate W relative to the hand 43 is deviated in a positive direction from an ideal position, the position of the hand 43 is fine-adjusted to a negative side. If the position of the substrate W relative to the hand 43 is deviated in a negative direction from the ideal position, the position of the hand 43 is fine-adjusted to a positive side. This allows the substrate W to be located more accurately in a predetermined position in the second processing unit 23B.

As described above, the substrate processing apparatus 1 detects the position of the edge E of the substrate W, based on the falling edge of the "High" signal, when the substrate W moves away from the detection positions of the optical sensors 46, and detects the position of the edge E of the substrate W, based on the rising edge of the "High" signal, when the substrate W moves toward the detection positions of the optical sensors 46. Thus, the position of the edge E of the substrate W is detected based on the signal of a portion closest to the outside of the substrate W among the "High" signals outputted near the edge E of the substrate W. This allows the position of the edge E of the transparent substrate W to be detected appropriately.

In particular, the optical sensors 46 are located near the home position of the hand 43 as seen in the movement direction in the present preferred embodiment. Specifically, the optical sensors 46 are located closer to the home position than the midpoint between the home position and the transfer position. Thus, the position of the edge E of the substrate W is detected when the movement speed of the substrate W is decreasing immediately before the hand 43 is stopped in the home position. This allows the position of the edge E of the substrate W to be detected more accurately.

In the present preferred embodiment, the optical sensors 46 include the first optical sensors 46A which detect the rear end portion of the substrate W as seen in the movement direction thereof, and the second optical sensors 46B which detect the front end portion of the substrate W as seen in the movement direction thereof. Thus, the detection of the rear and front end portions of the substrate W by means of the separate optical sensors 46A and 46B allows the signal only near the edge E of the substrate W to be acquired in a short time from the optical sensors 46A and 46B. Even if the substrate W has a light-blocking pattern near the center thereof, there is no need to distinguish between the "High" signal coming from the light-blocking pattern and the "High" signal coming from the beveled portion B of the substrate W. This allows the position of the edge E of the substrate W to be detected easily based on the "High" signal coming from the beveled portion B of the substrate W.

### <3. Modifications>

While the one preferred embodiment according to the present invention has been described hereinabove, the present invention is not limited to the aforementioned preferred embodiment.

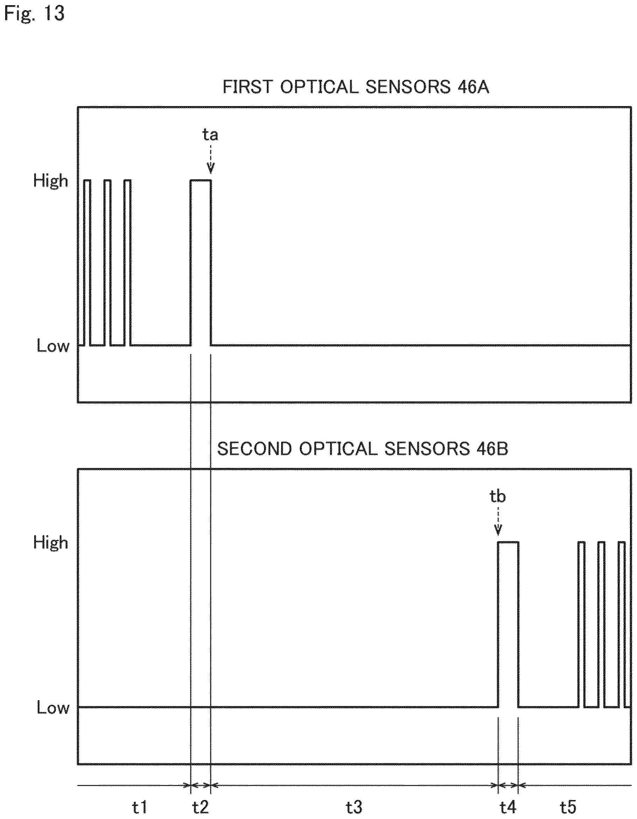

In the aforementioned preferred embodiment, the first optical sensors 46A and the second optical sensors 46B output the signals only near the edge E of the substrate W to the controller 30, as shown in Fig. 12. However, for example, signals outputted from the first optical sensors 46A and the second optical sensors 46B may include "High" signals coming from a light-blocking pattern inside the beveled portion B of the substrate W, as shown in Fig. 13.

In this case, the controller 30 may detect the position of the edge E of the substrate W, based on the time ta corresponding to the falling edge of the "High" signal in the situation where the substrate W moves away from the first detection position P1. Also, the controller 30 may detect the position of the edge E of the substrate W, based on the time tb corresponding to the rising edge of the "High" signal in the situation where the substrate W moves toward the second detection position P2.

In the aforementioned preferred embodiment, the optical sensors 46 detect the edge E of the substrate W in the course of the movement of the hand 43 from the transfer position to the home position. However, the optical sensors 46 may detect the edge E of the substrate W in the course of the movement of the hand 43 from the home position to the transfer position.

In Fig. 12, the signal outputted from the first optical sensors 46A and the signal outputted from the second optical sensors 46B are shown in different graphs. However, if the "High" signal from the first optical sensors 46A and the "High" signal from the second optical sensors 46B are not simultaneously outputted, the two output signals from the optical sensors 46A and 46B may be inputted to an OR circuit, so that a combined signal is outputted. Thus, the "High" signal from the first optical sensors 46A and the "High" signal from the second optical sensors 46B are acquired in the single output signal while the number of interconnect lines is reduced.

In the aforementioned preferred embodiment, the substrate W has the beveled portion B. However, the substrate W need not have the beveled portion B. For example, the edge E of the substrate W may be a vertical surface which is not tapered. Even in such a case, the "High" signal with a short time period is obtained by the scattering of the inspection light near the edge E of the substrate W. This allows the position of the edge E of the substrate W to be detected by the same method as in the aforementioned preferred embodiment, based on the "High" signal.

The operation of the transport robot 40 of the second transport part 22 transporting the substrate W between the two processing units 23 is described in the aforementioned preferred embodiment. However, the same transport process as described above may be performed when the transport robot 40 of the second transport part 22 transports the substrate W between the buffer 21 and the processing units 23. Also, the same transport process as described above may be performed when the transport robot 40 of the first transport part 12 transports the substrate W between the carriers C and the buffer 21.

In the aforementioned preferred embodiment, the light emitters 461 of the optical sensors 46 are disposed below the advancing/retracting path of the substrate W and the photodetectors 462 of the optical sensors 46 are disposed above the advancing/retracting path of the substrate W. However, the light emitters 461 of the optical sensors 46 may be disposed above the advancing/retracting path of the substrate W and the photodetectors 462 of the optical sensors 46 may be disposed below the advancing/retracting path of the substrate W.

Some of the components appearing in the aforementioned preferred embodiment and modifications may be omitted or other components may be added without departing from the spirit of the present invention.

While the invention has been shown and described in detail, the foregoing description is in all aspects illustrative and not restrictive. It is therefore understood that numerous modifications and variations can be devised without departing from the scope of the invention.

## Claims

1. A substrate processing apparatus (1) for processing a transparent substrate (W), comprising:
a hand (43) for holding a substrate (W);
an advancing/retracting mechanism (44) for moving said hand (43) back and forth along a predetermined advancing/retracting path;
at least one optical sensor (46) for emitting and receiving inspection light in a detection position (P1, P2) on said advancing/retracting path, said optical sensor (46) outputting a light blocking signal when the amount of inspection light received is lower than a threshold value; and
a controller (30) for detecting the position of an edge (E) of the substrate (W), based on said light blocking signal,
wherein said controller (30) detects the position of the edge (E) of the substrate (W), based on a rising edge of said light blocking signal, when the substrate (W) moves toward said detection position (P1, P2), and
wherein said controller (30) detects the position of the edge (E) of the substrate (W), based on a falling edge of said light blocking signal, when the substrate (W) moves away from said detection position (P1, P2).

2. The substrate processing apparatus (1) according to claim 1,
wherein said advancing/retracting mechanism (44) moves said hand (43) back and forth between a home position in which the substrate (W) is stored and a transfer position in which the substrate (W) is transferred, and
wherein said controller (30) detects the position of the edge (E) of the substrate (W) in the course of movement of said hand (43) from said transfer position to said home position.

3. The substrate processing apparatus (1) according to claim 2,
wherein said optical sensor (46) is located near said home position.

4. The substrate processing apparatus (1) according to any one of claims 1 to 3,
wherein said at least one optical sensor (46) includes:
a first optical sensor (46A) for detecting a rear end portion of the substrate (W) as seen in a movement direction thereof in a first detection position (P1) on said advancing/retracting path; and
a second optical sensor (46B) for detecting a front end portion of the substrate (W) as seen in the movement direction thereof in a second detection position (P2) closer to said home position than said first detection position (P1).

5. The substrate processing apparatus (1) according to any one of claims 1 to 4,
wherein said controller (30) calculates the position of the substrate (W) relative to said hand (43), based on the detected position of the edge (E).

6. The substrate processing apparatus (1) according to claim 5, further comprising:
a plurality of processing units (23); and
a transport robot (40) for transporting the substrate (W) between said processing units (23),
wherein said transport robot (40) includes said hand (43), said advancing/retracting mechanism (44), and said optical sensor (46),
wherein said controller (30) calculates said relative position when transporting the substrate (W) out of one of the processing units (23), and
wherein said controller (30) adjusts the position of said hand (43), based on said relative position, when transporting the substrate (W) into another of the processing units (23).

7. A method of processing a transparent substrate (W), comprising the steps of:
(a) emitting and receiving inspection light in a detection position (P 1, P2) on an advancing/retracting path of a substrate (W), and outputting a light blocking signal when the amount of inspection light received is lower than a threshold value; and
(b) detecting the position of an edge (E) of the substrate (W), based on said light blocking signal,
said steps (a) and (b) being performed by a controller (30),
wherein, in said step (b), said controller (30) detects the position of the edge (E) of the substrate (W), based on a rising edge of said light blocking signal, when the substrate (W) moves toward said detection position (P 1, P2), and detects the position of the edge (E) of the substrate (W), based on a falling edge of said light blocking signal, when the substrate (W) moves away from said detection position (P 1, P2).
